# EUROPÄISCHE PATENTANMELDUNG

(11) **EP 1 617 337 A2**
(43) Veröffentlichungstag der Anmeldung: **18.01.2006**
(21) Anmeldenummer: 05012716.6
(22) Anmeldetag: 14.06.2005
(51) Int. Cl.: G06F 13/40

(54) **Galvanische Trennung mittels Funktechnologien**

(30) Priorität: 14.07.2004 DE 102004034248
(71) Anmelder: Endress + Hauser Flowtec AG, 4153 Reinach BL 1 (CH)
(72) Erfinder: Roth, Jörg, 79540 Lörrach (DE); Roost, Matthias, CH-4144 Arlesheim (CH)
(74) Vertreter: Andres, Angelika Maria

(57) **Zusammenfassung**

Bei einer elektronischen Schaltung mit galvanisch getrennten Baugruppen erfolgt die Signalübertragung zwischen den Baugruppen A, B über eine Funkverbindung deren Reichweite einige Zentimeter beiträgt. Somit können Baugruppen A, B, die galvanisch getrennt sind, auch auf unterschiedlichen Leiterplatten LP1, LP2 angeordnet sein.

## Beschreibung

Die Erfindung betrifft eine Elektronische Schaltung mit galvanisch getrennten Baugruppen.

Vielfach ist es notwendig bei elektronischen Schaltungen einzelne Baugruppen galvanisch voneinander zu trennen. In der Regel werden hierfür Optokoppler oder Übertrager eingesetzt.

Optokoppler bestehen aus einer Leuchtdiode (LED-Diode) und einem lichtempfindlichen Halbleiter, z. B. einem Phototransistor. Die elektrischen Signale werden mit Hilfe der LED-Diode in Lichtsignale umgewandelt und auf der Empfängerseite mittels eines Phototransistors in elektrische Signale zurückgewandelt.

Übertrager bestehen aus Spulen, die magnetisch gekoppelt sind und so eine Signalübertragung zwischen den Spulen ermöglichen.

Derartige Optokoppler/Übertrager gestatten eine rückwirkungsfreie galvanisch getrennte Datenübertragung zwischen Baugruppen einer elektronischen Schaltung.

Häufig werden solche Optokoppler/Übertrager bei Sensorschaltungen in Feldgeräten der Prozessautomatisierungstechnik eingesetzt.

Zum einen um die Anforderungen für die Ex-Zulassungen dieser Geräte zu erfüllen oder um empfindliche Baugruppen z. B. vor Überspannungen zu schützen.

Ein Nachteil dieser Art der galvanischen Trennung besteht jedoch darin, daß Optokoppler/Übertrager prinzipiell nur zur Übertragung von Signalen über relativ kurze Strecken (wenige mm) geeignet sind. Dies hat einen entscheidenden Einfluß auf die Konzeption und den Aufbau einer elektronischen Schaltung. Entsprechende Baugruppen müssen notwendigerweise immer auf einer gemeinsamen Leiterplatte angeordnet sein.

Aufgabe der vorliegenden Erfindung ist es, eine Elektronische Schaltung mit galvanisch getrennten Baugruppen anzugeben, die die oben genannten Nachteile nicht aufweist, die insbesondere einen größeren Abstand zwischen einzelnen Baugruppen ermöglicht.

Gelöst wird diese Aufgabe durch die im Anspruch 1 angegebenen Merkmale. Vorteilhafte Weiterentwicklungen der Erfindung sind in den Unteransprüchen angegeben.

Die wesentliche Idee der Erfindung besteht darin, daß die Signalübertragung zwischen den Baugruppen mittels einer Funkverbindung erfolgt. Eine Funkverbindung erfüllt die Anforderungen für eine galvanische Trennung. Die Reichweite von einigen Zentimetern reicht für typische elektronische Schaltungen aus.

Dadurch ist es möglich, Baugruppen, die eine galvanische Trennung erfordern, auch auf unterschiedlichen Leiterplatten anzuordnen. Diese Anordnung bietet erhebliche Vorteile bei der Konzeption von elektronischen Schaltungen.

In einer Weiterentwicklung der Erfindung erfolgt die Signalübertragung digital.

In einer Weiterentwicklung der Erfindung erfolgt die Datenübertragung seriell.

Ein weiterer Vorteil, den eine Funkübertragung bietet, besteht darin, daß die Datenübertragung in einfacher Weise auch bidirektional erfolgen kann.

Mit Hilfe einer Funkübertragung kann auch ein Systembus mit einem Mikroprozessor und mehreren Teilnehmern (wie ROM, EEPROM, E/A-Ports, Eingabeeinheit, Anzeigeeinheit, etc.) realisiert werden.

Eine Baugruppe, bei der eine bidirektionale Datenübertragung von großer Wichtigkeit ist, sind Mikrocontroller mit E/A-Ports insbesondere bei Feldgeräten wie z. B. Massedurchflussmessgeräte, Füllstandsmessgeräte, Druck- und Temperaturmessgeräte. Eine Vielzahl solcher Feldgeräte wird von der Fa. Endress + Hauser hergestellt und vertrieben.

Nachfolgend ist die Zeichnung anhand eines in der Zeichnung dargestellten Ausführungsbeispiels näher erläutert.

Es zeigen:
- Fig. 1: Elektronische Schaltung mit zwei galvanisch getrennten Baugruppen, die über einen Optokoppler verbunden sind, in schematischer Darstellung;
- Fig. 2: Elektronische Schaltung mit zwei galvanisch getrennten Baugruppen gemäß der Erfindung in schematischer Darstellung;
- Fig. 3: Detaildarstellung der erfindungsgemäßen Schaltung gemäß Fig. 2.

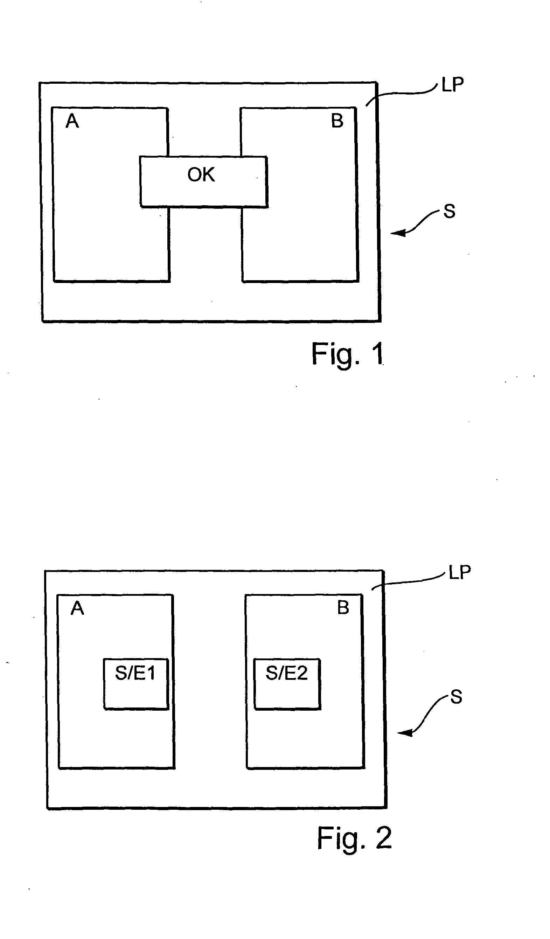

In Fig. 1 ist eine elektronische Schaltung S mit zwei Baugruppen A und B dargestellt. Die beiden Baugruppen A und B sind auf einer gemeinsamen Leiterplatte L angeordnet. Ein Optokoppler OK dient zur Signalübertragung zwischen den beiden Baugruppen A und B. Dies ist ein typischer Aufbau einer elektronischen Schaltung mit zwei galvanisch getrennten Baugruppen A und B. Es besteht also keine elektrisch leitende Verbindung zwischen den beiden Baugruppen.

Fig. 2 zeigt eine erfindungsgemäße elektronische Schaltung in einer Prinzipdarstellung. Die Datenübertragung zwischen den Baugruppen A und B erfolgt mit Hilfe der Sende/Empfängereinheiten S/E1 bzw. S/E2. Die beiden
Baugruppen A und B können auf einer gemeinsamen Leiterplatte oder aber auch auf getrennten Leiterplatten angeordnet sein.

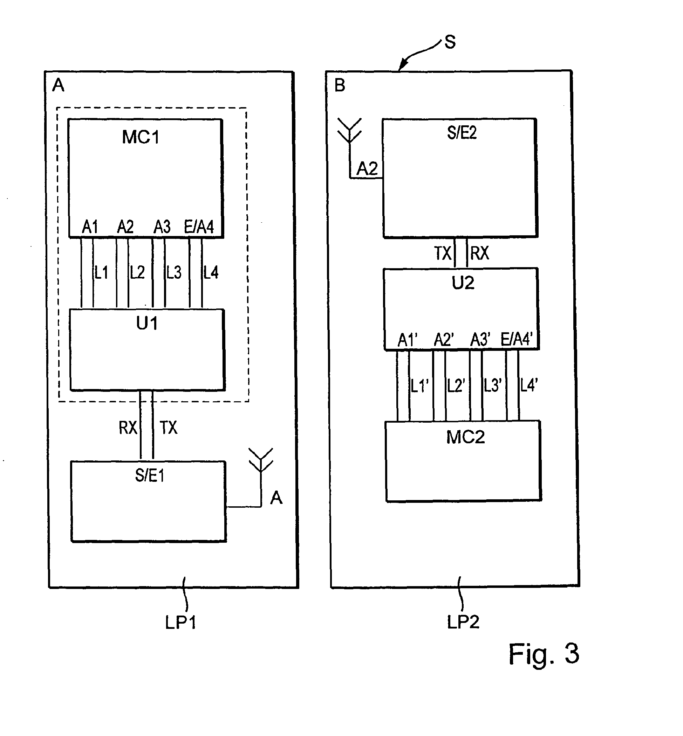

In Fig. 3 ist eine Detaildarstellung einer erfindungsgemäßen Vorrichtung näher erläutert.

Auf einer Leiterplatte LP1 sind ein Mikrocontroller MC1, eine Umsetzereinheit U1 und eine Sende/Empfangseinheit E/E1als Teile einer Baugruppe A einer elektronischen Schaltung S angeordnet.
Der Mikrocontroller MC ist über mehrere Datenleitungen L mit einer Umsetzereinheit U verbunden. Dargestellt sind die drei Datenleitungspaare für die Ausgänge A1, A2 und A3 des Mikrocontrollers MC. Bei dem vierten Anschluß handelt es sich um einen Ein/Ausgang E/A 4. Vom Ein/Ausgang E/A4 führt ein weiteres Leitungspaar L4 zur Umsetzereinheit U1. Die Umsetzereinheit U1 kann auch direkt im Mikrocontroller MC integriert sein. Über die Leitungspaare L1 bis L3 erfolgt die Datenübertragung unidirektional vom Mikrocontroller MC1 zur Umsetzereinheit U1. Nur über das Leitungspaar L4 erfolgt eine bidirektionale Kommunikation zwischen Mikrocontroller MC1 und der Umsetzereinheit U1. Die Umsetzereinheit U1 erzeugt aus den vom Mikrocontroller MC übertragenen Daten einen seriellen Datenstrom, der über Verbindungsleitungen (TX, RX) an die Sendeempfangseinheit S/E1 weitergegeben wird. Die Sendeempfängereinheit S/E1 ist mit einer Antenne A1 verbunden. Die Sendeempfängereinheit S/E1 kommuniziert über eine Funkverbindung mit einer zweiten Sendeempfängereinheit S/E2, die auf einer zweiten
Leiterplatte LP2 angeordnet ist und die Teil einer zweiten Baugruppe B ist. Zur Baugruppe B gehören noch eine Umsetzereinheit U2 und ein Mikrocontroller MC2.

Zum Empfangen und Abstrahlen der Funksignale dient eine mit der Sende/Empfangseinheit E/A2 verbundene Antenne A2.

Die Sendeempfangseinheit S/E2 ist über Signalleitungen TX, RX mit der Umsetzereinheit U2 verbunden. Die Umsetzereinheit U2 setzt den von der Sendeempfangseinheit S/E empfangenen seriellen Datenstrom in einem parallelen Datenstrom um und gibt diesem über ihre Ausgänge A1', A2', A3' und E/A4' an den Mikrocontroller MC2 weiter.

Bei der Baugruppe A kann es sich z.B. um den Sensorteil eines Feldgerätes handeln. In diesem Fall wäre der Mikrocontroller MC1 über einen analog/digital Wandler mit einem Meßaufnehmer verbunden.

Bei der Baugruppe B könnte es sich um den Kommunikationsteil (z. B. Profibus- oder Foundation Fieldbus-Schnittstelle) eines Feldgerätes handeln. In diesem Fall wäre der Mikrocontroller MC2 mit über Busanschalteinheit (MAU Medium Access Unit) mit einem Feldbus verbunden.

Die Erfindung erlaubt in einfacher Weise eine galvanische Trennung zwischen Baugruppen einer elektronischen Schaltung. Aufgrund der Reichweite der Funkverbindung von einigen Zentimetern können die Baugruppen A und B selbstverständlich auch auf unterschiedlichen Leiterplatten LP1, LP2 angeordnet sein.

Dies ergibt erhebliche Vorteile bei der Konzeption und dem Aufbau von elektronischen Schaltungen. Der modulare Aufbau erlaubt die kostengünstige Herstellung von Geräten insbesondere von Feldgeräten der Automatisierungstechnik.

Da der Mikrokontroller MC1, MC2 nicht nur Ausgangssignale erzeugt sondern auch Eingangssignale verarbeitet, ist eine bidirektionale Datenübertragung zwischen den einzelnen Baugruppen A und B vorgesehen.

Mit Hilfe der Erfindung ist auch die Realisierung eines Systembusses bei elektronischen Schaltungen, die Mikrocontroller und verschiedene Peripherieeinheiten (z. B. ROM-, EEPROM-Speicher, I/O-Ports, Eingabeeinheiten, Ausgabeeinheiten) aufweisen möglich.

## Patentansprüche

1. Elektronische Schaltung mit galvanisch getrennten Baugruppen, **dadurch gekennzeichnet, dass** die Signalübertragung zwischen den Baugruppen über eine Funkverbindung erfolgt, die eine Reichweite von einigen Zentimetern hat.

2. Elektronische Schaltung nach Anspruch 1, **dadurch gekennzeichnet, dass** die Baugruppen A, B auf getrennten Leiterplatten LP1, LP2 angeordnet sind.

3. Elektronische Schaltung nach einem der vorhergehenden Ansprüche, **dadurch gekennzeichnet, dass** die Signalübertragung seriell digital erfolgt.

4. Elektronische Schaltung nach einem der vorhergehenden Ansprüche, **dadurch gekennzeichnet, dass** die Signalübertragung bidirektional erfolgt.

5. Schaltung nach einem der vorhergehenden Ansprüche, **dadurch gekennzeichnet, dass** eine der Baugruppen einen Mikrocontroller MC umfasst.

6. Elektronische Schaltung nach einem der vorhergehenden Ansprüche, **dadurch gekennzeichnet, dass** die Baugruppen mehrere Teilnehmer eines Systembusses sind.

7. Feldgerät der Automatisierungstechnik, **dadurch gekennzeichnet, dass** es eine elektronische Schaltung nach einem der vorhergehenden Ansprüche aufweist.
